# EUROPÄISCHE PATENTSCHRIFT

(11) **EP 0 432 640 B1**
(45) Veröffentlichungstag und Bekanntmachung des Hinweises auf die Patenterteilung: **23.11.1994**
(21) Anmeldenummer: 90123410.4
(22) Anmeldetag: 06.12.1990
(51) Int. Cl.: G01R 31/36

(54) **Überwachungseinrichtung für Akkumulatoren**
Monitoring device for accumulators
Dispositif de surveillance pour accumulateurs

(30) Priorität: 12.12.1989 DE 3940929
(43) Veröffentlichungstag der Anmeldung: 19.06.1991
(73) Patentinhaber: FRAUNHOFER-GESELLSCHAFT ZUR FÖRDERUNG DER ANGEWANDTEN FORSCHUNG E.V., 80636 München (DE)
(72) Erfinder: Schmidt, Heribert, Dr., W-7830 Emmendingen 13 (DE)
(74) Vertreter: Rackette, Karl, Dipl.-Phys. Dr.-Ing

(56) Entgegenhaltungen:
- EP-A- 0 112 242
- WO-A-90/02440
- GB-A- 1 001 913
- US-A- 3 202 900
- US-A- 4 484 140

## Beschreibung

Die Erfindung betrifft eine Überwachungseinrichtung für eine Vielzahl von in Reihe geschalteten, gleichartigen Akkumulatoren, mit einer Steuerschaltung zum Zuschalten eines elektrischen Speichers parallel zu einem der Akkumulatoren.

Aus dem Prospektblatt ZAT 100 der Helmut Händel + Partner, Meßdatentechnik KG, 8031 Eichenau, ist eine zyklische Überwachungseinrichtung für Akkumulatoren bekannt, bei der jeweils ein Akkumulator unterbrechungsfrei aus dem Akkumulatorsystem getrennt und geprüft wird. Wird ein Akkumulator von der Überwachungseinrichtung als schlecht bewertet, so wird der entsprechende Akkumulator markiert, damit er ausgewechselt werden kann.

Bis ein solcher, in seiner Speicherungs- und Ladungsqualität absinkender Akkumulator von der Überwachungseinrichtung für Akkumulatoren erkannt wird, führt sein Fehlverhalten zu einer Kette von Reaktionen im Akkumulatorengesamtsystem, was zu einer Degradation auch der anderen Akkumulatoren führt.

In der DE-OS 20 21 531 ist eine Vorrichtung zur Verlängerung der Entladungsdauer von wiederaufladbaren Akkumulatoren beschrieben, bei der durch Einschleifen einer Spule in einen Gleichstrom-Stromkreis auftretende Induktionsströme über einen Kondensator wieder der Stromquelle zugeführt werden. Es wird eine Verlängerung der Entladungsdauer der Akkumulatoren dadurch bewirkt, daß die Last mit einem kleiner als Eins ausgelegten Tastverhältnis an die Akkumulatoren angeschaltet ist. Eine Verlängerung der Standzeit von Akkumulatoren im Hinblick auf ihre Auswechslung läßt sich damit nicht erreichen. Insbesondere können in ihrer Qualität schlechter werdende Akkumulatoren nicht erkannt werden.

Aus der SU 1 046 805 ist eine Vorrichtung mit über Schalter in den Gleichstromkreis eingeschalteten Kondensatoren bekannt, mit denen das Überladen bzw. das vollständige Entladen von Akkumulatoren verhindert wird. Dabei werden die Kondensatoren zur Bildung einer Zeitkonstanten eingesetzt, die jedoch weder die Überwachung der Qualität der Akkumulatoren gewährleisten, noch eine längere Standzeit von in ihrer Qualität schlechter werdenden Akkumulatoren bewirken.

Ausgehend von diesem Stand der Technik liegt der Erfindung die Aufgabe zugrunde, eine Überwachungseinrichtung für Akkumulatoren zu schaffen, bei dem der Austausch eines in seiner Qualität schlechteren Akkumulators hinausgezögert werden kann.

Diese Aufgabe wird erfindungsgemäß dadurch gelöst, daß die Polanschlüsse jeden Akkumulators über ein zugehöriges Schalterpaar an einen, den elektrischen Speicher bildenden Kondensator angeschlossen sind und daß die Schalterpaare über Steuerleitungen mit der Steuerschaltung verbunden sind, wobei die Steuerschaltung gleichzeitig jeweils höchstens eine Steuerleitung mit einem Schließsignal beaufschlagt.

Wenn die Steuerschaltung nacheinander die Verbindung zwischen jeweils einem Akkumulator und dem Kondensator schaltet, gleichen sich die an dem Kondensator anliegende Spannung und die Spannung des ausgewählten Akkumulators durch einen Ladungsausgleich einander an. Falls die Akkumulatorspannung höher als die über dem Kondensator anliegende Spannung ist, fließen Ladungen aus dem Akkumulator ab, so daß dessen Spannung sinkt. Falls die an dem Kondensator anliegende Spannung größer als die Akkumulatorspannung ist, erhöht sich durch den Ladungsfluß aus dem Kondensator die Akkumulatorspannung. Dadurch werden sowohl langsam aufladende als auch schnell aufladende Akkumulatoren auf einen mittleren Spannungswert zurückgeführt, der eine lange Standzeit der Akkumulatorengruppe mit vielen Aufladungs- und Entladungszyklen bei einer unterschiedlichen Lade- und Entlade-Qualität der sie aufbauenden Akkumulatoren gestattet.

Dadurch, daß der Kondensator im Anschluß an einen solchen Ausgleichsvorgang an einen anderen Akkumulator angeschlossen wird, bildet die Spannung des vorherigen Akkumulators, die dann der Spannung des Kondensators entspricht, für diesen eine Referenzspannung.

Ein sehr einfacher Aufbau der Steuerschaltung ergibt sich, wenn die mit dem Schließsignal beaufschlagte Steuerleitung aus der Vielzahl der Steuerleitungen zufällig durch ein in der Steuerschaltung vorliegendes Rauschsignal ermittelt wird.

Wenn in der Steuerschaltung ein EPROM oder eine andere Speichereinrichtung vorgesehen ist, kann eine Auswahlsequenz für die nacheinander mit dem Schließsignal zu beaufschlagenden Steuerleitungen abgelegt werden, die einer Pseudo-Zufallsfunktion entspricht.

Bei einer anderen Weiterbildung der Erfindung ist eine Vergleichsschaltung vorgesehen, mit der die Abweichungen der Akkumulatorspannung von einer Sollspannung meßbar ist. Diese wird in der Steuerschaltung als Differenz-Istspannung für den jeweiligen Akkumulator gespeichert. In der Steuerschaltung werden dann Schließsignale für Schalterpaare von solchen Akkumulatoren hintereinander erzeugt, deren Differenz-Istspannungen positiv bzw. negativ sind. Damit wird erreicht, daß im Anschluß an einen höher aufgeladenen Akkumulator, der den Kondensator auflädt, ein schlechter aufladender Akkumulator ausgewählt wird, in den die in dem Kondensator gespeicherte Ladung fließen kann.

In der Vergleichsschaltung kann vorgesehen sein, die an dem Kondensator anliegende Spannung zu Zeiten zu erfassen, in denen keine Steuerleitungen mit einem Schließsignal beaufschlagt ist, so daß jeweils die Nennspannung des zuletzt angeschlossenen Akkumulators ermittelt wird.

In einem modularen Aufbau der Überwachungseinrichtung für Akkumulatoren ist eine Vergleichsschaltung je Akkumulator vorgesehen, deren jeweiliger Ausgang mit einem dem jeweiligen Akkumulator zugeordneten Eingang der Steuerschaltung verbunden ist.

Weitere Ausgestaltungen der Erfindung sind in den Unteransprüchen gekennzeichnet. Nachfolgend werden Ausführungsbeispiele der Erfindung anhand der Zeichnung näher erläutert. Es zeigen:
- Fig. 1: ein Blockschaltbild einer Überwachungseinrichtung für drei Akkumulatoren,
- Fig. 2: ein Schaltbild eines mit Triacs realisierten Schalterpaares,
- Fig. 3: Beispiel für eine Realisierungsmöglichkeit für eine Vergleichsschaltung einer Überwachungseinrichtung,
- Fig. 4: eine Ansteuerschaltung der Überwachungseinrichtung für Akkumulatoren und
- Fig. 5: eine zweite Realisierung für eine Vergleichsschaltung einer Überwachungseinrichtung für Akkumulatoren.

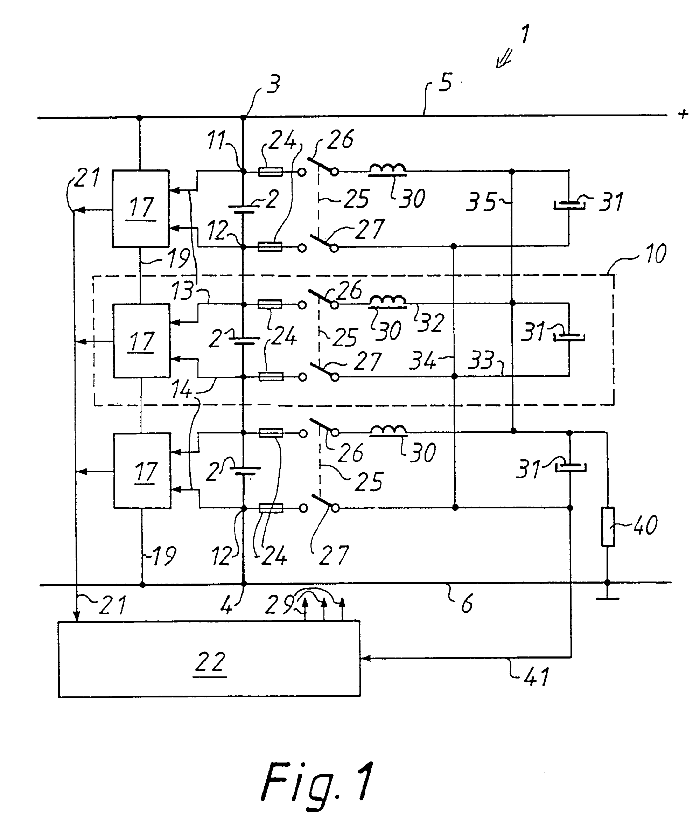

Die Fig. 1 zeigt ein Blockschaltbild einer Überwachungseinrichtung 1 für Akkumulatoren zur Überwachung von z.B. drei Akkumulatoren 2. In üblichen Spannungsversorgungen mit Akkumulatoren 2 sind z.B. 35 6-Volt-Akkumulatoren zusammengeschaltet um eine Spannung von ungefähr 200 Volt zu erzeugen. Die in der Fig. 1 dargestellten drei Akkumulatoren 2 sind in Reihe geschaltet und werden an den Hauptanschlußpunkten 3 und 4 an zwei Hauptleitungen 5 und 6 angeschlossen, von denen üblicherweise die Hauptleitung 6 die Masseleitung ist und sich die Hauptleitung 5 auf einem positiven Potential befindet.

Die Hauptleitungen 5 und 6 sind zum Laden der Akkumulatoren 2 an einem in der Fig. 1 nicht dargestellten Solargenerator angeschlossen. Desweiteren ist üblicherweise eine in der Fig. 1 ebenfalls nicht dargestellte Last an die Akkumulatoren 2 angeschlossen. Diese bewirkt eine Entladung der Akkumulatoren 2. Je nach Sonneneinstrahlung auf die Solargeneratoren bzw. die Ladungsentnahme durch die angeschlossene Last schwankt der Ladungszustand der Akkumulatoren 2 beträchtlich. Die Überwachungseinrichtung 1 regelt die Ladung und die Entladung der Akkumulatoren 2 bei Ladungszuständen von diesen zwischen vollgeladen und ganz entladen.

Jeder Akkumulator 2 ist Bestandteil eines Überwachungsmodules 10 der Überwachungseinrichtung 1. Der Aufbau eines der hier drei Überwachungsmodule 10 wird beispielhaft im folgenden beschrieben.

Der Akkumulator 2 jedes Überwachungsmodules 10 verfügt über zwei externe Anschlußpunkte 11 und 12, an denen die Gesamtspannung des Akkumulators 2 anliegt. Über die Anschlußpunkte 11 und 12 ist jedes Überwachungsmodul mit dem benachbarten Überwachungsmodul 10 bzw. mit den Hauptleitungen 5 oder 6 verbunden.

Im Idealfall von Akkumulatoren 2 gleicher Güte liegt zwischen den Anschlußpunkten 11 und 12 eines jeden Überwachungsmodules 10 die gleiche Spannung an, nämlich ein Drittel der Gesamtspannung des Akkumulatorsystems bei drei Akkumulatoren 2. Die zwischen den Anschlußpunkten 11 und 12 abgegriffene Spannung beaufschlagt über Istwertleitungen 13 und 14 eine Vergleichsschaltung 17.

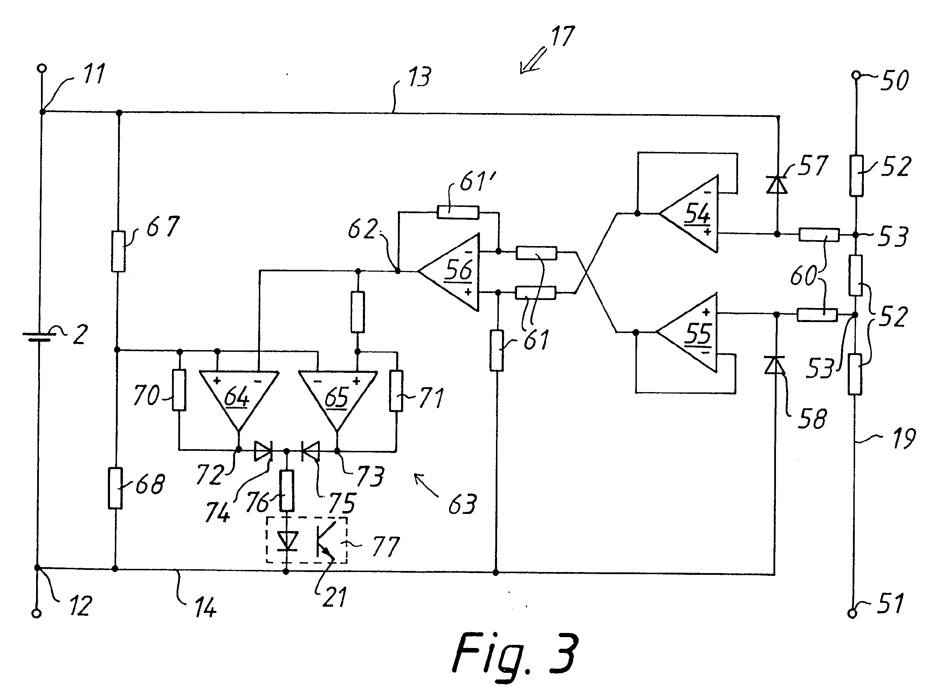

Vorteilhafterweise verfügt die Vergleichsschaltung 17 über eine über schematisch dargestellte Außenleitungen 19 anliegende Referenzspannung. Diese kann, wie in Fig. 3 dargestellt, durch einen Spannungsteiler erzeugt werden. Die Vergleichsschaltung 17 bildet aus der durch die Außenleitung 19 vorgegebenen, augenblicklichen Sollspannung des Akkumulators 2 und der augenblicklichen Istspannung des Akkumulators 2 eine Differenzspannung, die über eine schematisch dargestellte Steuerleitung 21 eine Ansteuerschaltung 22 beaufschlagt. Der von der Vergleichsschaltung 17 der Überwachungsmodule 10 in die Ansteuerschaltung 22 führende Pfeil beschreibt schematisch einen Datenbus mit einer Vielzahl von Leitungen. Es kann auch eine einzige Leitung vorgesehen sein, wobei die Ausgänge der Vergleichsschaltungen 17 in einer verdrahteten ODER-Verknüpfung verbunden sind.

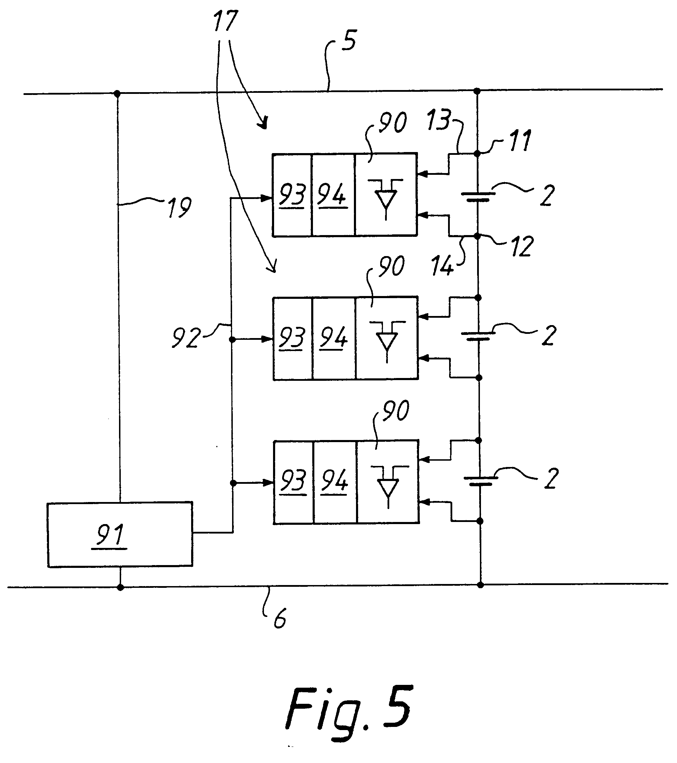

Zwei Ausführungsformen der Vergleichsschaltung 17 sind in den Fig 3 und 5 dargestellt. Die auf den Steuerleitungen 21 transportierten Steuersignale bestehen z.B. aus einem, zwei Werte umfassenden Ausgangssignal eines Fensterkomparators.

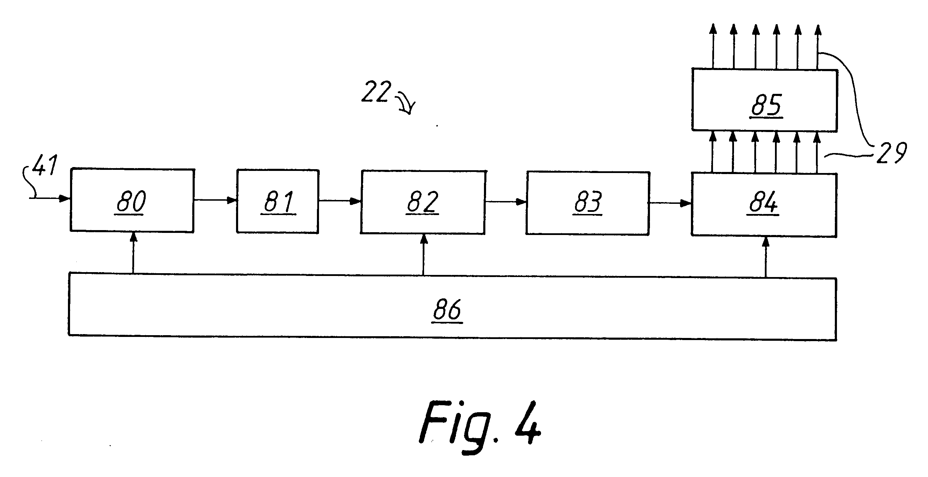

Der Aufbau einer Ansteuerschaltung 22 ist im Zusammenhang mit der Fig. 4 näher beschrieben.

Die Anschlußpunkte 11 und 12 des Akkumulators 2 in jedem Überwachungsmodul 10 sind über jeweils eine Sicherung 24 mit einem Schalterpaar 25 mit zwei Schaltkontakten 26 und 27 verbunden. Das Schalterpaar 25 eines jeden Überwachungsmodules 10 ist über in der Fig. 1 nur schematisch an der Ansteuerschaltung 22 skizzierte Steuerleitungen 29 an die Ansteuerschaltung 22 angeschlossen. Das Schalterpaar 25 ist vorteilhafterweise so ausgestaltet, daß die Schaltkontakte 26 und 27 im wesentlichen gleichzeitig öffnen und schließen.

An jedem Schalterpaar 25 ist über eine Spule 30 ein Kondensator 31 angeschlossen, so daß bei geschlossenem Schalterpaar 25 der jeweilige Akkumulator 2 und der zugehörige Kondensator 31 parallel geschaltet sind. Die Spule 30 ist in die vom Anschlußpunkt 11 zum Kondensator 31 hinführende Leitung 32 eingesetzt. In jedem Überwachungsmodul 10 liegt bei einem geschlossenen Schalterpaar 25 die Kondensatorleitung 32 auf einem höheren Potential als die Kondensatorleitung 33. Die Kondensatorleitungen 32 bzw. 33 der einzelnen Überwachungsmodule 10 sind über Verbindungsleitungen 34 und 35 mit den entsprechenden Kondensatorleitungen 32 und 33 der anderen Überwachungsmodule 10 verbunden. Dadurch bildet sich ein aus den drei Kondensatoren 31 bestehen des Kondensatormittel mit dreifacher Kapazität eines Einzel-Kondensators 31.

Beim Laden der Akkumulatoren 2 wird den Akkumulatoren 2 durch die Solarzellen oder z.B. von einem Dieselmotor-Stromgenerator Ladung zugeführt. Die jeweilige Spannung jedes Akkumulators 2 wird mit seiner Sollspannung in der Vergleichsschaltung 17 verglichen und das Ergebnis direkt in Gestalt einer analogen Spannung oder als Ausgangssignal eines Fensterkomparators an die Ansteuerschaltung 22 weitergeleitet und in dieser vorzugsweise gespeichert. Nun gibt es bei der Hintereinanderschaltung von üblicherweise 30 und mehr Akkumulatoren 2 einige Akkumulatoren 2, die schlechter aufladen als andere Akkumulatoren 2 und andere die besser und schneller aufladen als der Durchschnitt der verwendeten Akkumulatoren 2.

Im ersten Fall äußert sich diese in einer jeweils geringeren Istspannung des betreffenden Akkumulators 2. Zur Unterstützung des Ladungsvorgangs dieses Akkumulators 2 wird zunächst das Schalterpaar 25 eines höher aufgeladenen Akkumulators 2 geschlossen. Damit werden die Kondensatoren 31 auf das Spannungsniveau des höher aufgeladenen Akkumulator 2 aufgeladen. Dabei begrenzt die zu dem Schalterpaar 25 gehörige Spule 30 den Einschaltstrom bei der Ladung der Kondensatoren 31. Nach einer vorgegebenen Lade- und Ausgleichszeit wird das Schalterpaar 25 des gut aufladenden Akkumulators 2 geöffnet und nach einer kurzen Totzeit das Schalterpaar 25 des oben genannten schwächer aufladenden Akkumulators 2 geschlossen. Jetzt liegt an dem schwachen Akkumulator 2 die Spannung der Kondensatoren 31 an, die der Spannung des gut aufladenden Akkumulators 2 entspricht. Damit fließen Ladungen aus den Kondensatoren 31 in den schwächer aufladenden Akkumulator 2 und gleichen dessen schwächere Aufladung durch einen etwas erhöhten Energiezufluß aus.

Im zweiten obigen Fall gibt es Akkumulatoren 2 in dem Akkumulatorsystem, die besonders gut und schneller als der Durchschnitt der Akkumulatoren aufladen. Durch ein Beschalten der Kondensatoren 31 mittels eines Schalterpaares 25 auf einen durchschnittlich gut aufladenden Akkumulator 2 wird die Spannung der Kondensatoren 31 auf dessen Spannung gebracht. Dadurch, daß nun bevorzugt der sehr gut aufladende Akkumulator 2 angeschaltet wird, wird die in diesen hineinfließende, überschüssige Ladung in die eine schwächere Spannung aufweisenden Kondensatoren 31 fließen.

Die Auswahl der mit einem Schließsignal beaufschlagten Steuerleitungen 21 in der Ansteuerschaltung 22 ist vorzugsweise so getroffen, daß die Ansteuerschaltung 22 die Kondensatoren 31 zwischen besonders gut aufladenden und besonders schlecht aufladenden Akkumulatoren 2 hin und her schaltet und durchschnittlich aufladende Akkumulatoren 2 nicht oder nur selten mit den Kondensatoren 31 verbindet.

Die oben beschriebenen Ausgleichsvorgänge beim Laden von unterschiedlich gut aufladenden Akkumulatoren 2 gelten analog für die Ausgleichsvorgänge, die beim Entladen derselben Akkumulatoren 2 auftreten.

In der Überwachungseinrichtung 1 für Akkumulatoren muß gewährleistet sein, daß nie zwei Akkumulatoren 2 gleichzeitig über Schalterpaare 25 auf die Kondensatoren 31 geschaltet sind, da sonst ein Kurzschluß auftritt. Daher ist ein Widerstand 40 zwischen der Masseleitung 6 und der Kondensatorleitung 32 des an dem Hauptanschlußpunkt 4 angeschalteten, untersten Akkumulators 2 geschaltet. Sind alle Schalterpaare 25 geöffnet, so befinden sich alle Kondensatorleitungen 32 der überwachungsmodule 10 auf dem Potential der Masseleitung 6. Damit sinkt das Potential der Kondensatorleitungen 33 durch den zumindest teilweise aufgeladenen Kondensator 31 auf ein gegenüber der Masseleitung 6 negatives Potential, welches sich aus der negativen Akkumulatorspannung herleitet und das über eine Schalterzustandsleitung 41 an die Ansteuerschaltung 22 weitergeleitet und -gemeldet wird. Ist eines der Schalterpaare 25 dagegen geschlossen, so verbleibt das Potential der Leitungen 32 positiv gegenüber dem Potential der Masseleitung 6 oder entspricht diesem.

Die zum Schutz der Überwachungseinrichtung 1 vorgesehenen Sicherungen 24 können selbstrücksetzende Sicherungen oder einfache Schmelzsicherungen sein. Bei Auslösung der Schmelzsicherungen ist der zugehörige Akkumulator 2 vom Ladungsausgleich über die Akkumulatorsicherungseinrichtung ausgeschlossen. Das Ansprechen der Schmelzsicherungen wird vorzugsweise einem menschlichen Bediener der Überwachungseinrichtung 1 für Akkumulatoren 2 optisch angezeigt.

Das in der Fig. 1 gezeigte Ausführungsbeispiel weist einen vorteilhaften modularen Aufbau auf, der in jedem Überwachungsmodul aus einem Schalterpaar 25, einer Spule 30, einem Kondensator 31 und gegebenenfalls aus einer Vergleichsschaltung 17 besteht. Bei einer Überwachung von 33 in Reihe geschalteten 6- bis 12-Volt-Akkumulatoren 2 reicht bei einer Schaltfrequenz von 100 Hertz eine Kapazität von ungefähr 25 Millifarad bei 6 Volt für jeden Kondensator 31 aus.

Neben einer Vielzahl von modularen Vergleichsschaltungen 17 kann auch eine einzige, parallel zu den Kondensatoren 31 geschaltete Vergleichsschaltung 17 vorgesehen sein, mit der die an den Kondensatoren 31 anliegende Kondensatorspannung zu Zeiten erfaßt wird, in denen keine Steuerleitung 29 mit einem Schließsignal beaufschlagt ist. Ein entsprechendes Zeitsignal liegt vorteilhafterweise schon auf der Schalterzustandsleitung 41 vor.

Anstatt der direkten Weitermeldung der Differenz-Istspannung auf der Steuerleitung 21 kann auch die Abweichung der Akkumulatorspannung von der Sollspannung nach oben und nach unten außerhalb eines Spannungsfensters weitergeleitet werden. Vorteilhafterweise wird ein drei Werte umfassendes Ausgangssignal in der Ansteuerschaltung 22 für den jeweiligen Akkumulator 2 gespeichert, wobei einer der Werte das Überschreiten des Spannungsfensters und ein anderer das Unterschreiten des Spannungsfensters anzeigt. Mit der Ansteuerschaltung 22 sind dann Schließsignale für Schalterpaare 25 von solchen Akkumulatoren 2 hintereinander erzeugbar, für die Signale gespeichert sind, die ein Überschreiten und ein Unterschreiten signalisieren. Dadurch wird ein direkter Ladungsfluß von jeweils einem hoch aufgeladenen Akkumulator 2 über die Kondensatoren 31 direkt in einen schwach aufgeladenen Akkumulator 2 erzeugt und umgekehrt.

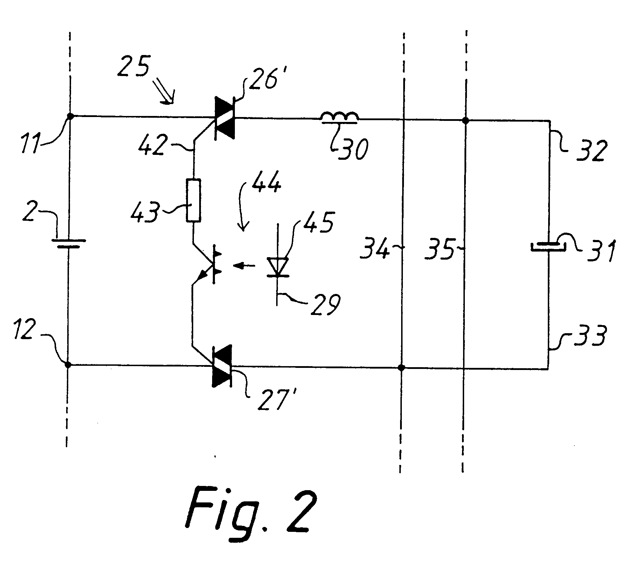

Die Fig. 2 zeigt einen detaillierteren Ausschnitt eines Überwachungsmodules 10 mit einer möglichen Ausführungsform für ein Schalterpaar 25. Für ein Schalterpaar 25 können Relais oder in Paaren antiparallel geschaltete Schalttransistoren verwendet werden. Vorteilhafterweise werden für das Schalterpaar 25 Triacs 26′ und 27′ eingesetzt. Dies sind symmetrisch aufgebaute Thyristoren. Diese lassen sich bei größeren positiven und negativen Anodenspannungen und kleineren Gate-Impulsen zünden.

Die Kathoden der Triacs 26′ und 27′ sind jeweils mit den Polanschlüssen 11 und 12 der Akkumulatoren 2 verbunden. Zwischen den Gate-Anschlüssen der Triacs 26′ und 27′ ist der Empfangsteil eines opto-elektronischen Kopplers 44, auch kurz mit Optokoppler bezeichnet, und ein Verlustwiderstand 43 in Reihe auf einer Gate-Leitung 42 geschaltet. Der Emitter-Diodenteil 45 des opto-elektronischen Kopplers 44 ist mit den Steuerleitungen 29 der Ansteuerschaltung 22 verbunden.

Zum Schließen eines Schalterpaares 25 wird die zugehörige Ansteuerleitung 29 mit einem Schließsignal beaufschlagt, das zur Lichtemission des Emitter-Diodenteils 45 des opto-elektronischen Kopplers 44 führt. Dadurch werden über die leitend gewordene Gate-Leitung 42 Gate-Spannungen an den Triacs 26′ und 27′ erzeugt, so daß diese beide gleichzeitig zünden. Falls der Ladungszustand des Akkumulators 2 von dem der Kondensatoren 31, von denen in der Fig. 2 nur der zu dem Überwachungsmodul 10 gehörende Kondensator 31 gezeichnet ist, nach oben oder nach unten abweicht, fließt ein Ausgleichsstrom über die Kondensatorleitungen 32 und 33, der in seinem zeitlichen Beginn durch die Induktivität der Spule 30 beschränkt wird.

Durch das Fließen des Ausgleichsstroms bleiben die Triacs 26′ und 27′ auch ohne ein kontinuierlich anliegendes Schließsignal leitend. Nachdem der Ladungs- und Spannungsausgleich zwischen dem beschalteten Akkumulator 2 und den Kondensatoren 31 stattgefunden hat und der Ausgleichsstrom unter den Haltestrom fällt, werden die Triacs 26′ und 27′ wieder nichtleitend. Dieser Zustand kann mit Hilfe des in der Fig. 1 beschriebenen Widerstandes 40 und der Schalterzustandsleitung 41 festgestellt werden, so daß die Ansteuerschaltung den nächsten Akkumulator 2 auf die Kondensatoren 31 schalten kann.

Die Triacs 26′ und 27′ weisen vorzugsweise eine möglichst niedrige Durchlaßspannung auf. Die Länge des Zündpulses, der anstelle durch einen opto-elektronischen Koppler 44 auch durch einen Transformator geliefert werden kann, wird so vorherbestimmt, daß beide Triacs 26′ und 27′ unter allen Betriebsbedingungen sicher zünden.

Die Fig. 3 zeigt ein Schaltbild einer Realisierungsmöglichkeit für die Vergleichsschaltung 17. Die Anschlußleitung 19, die in der Fig. 1 nur schematisch dargestellt war, verläuft zwischen dem Anschlußpunkt der positiven Sollspannung 50 und dem Anschlußpunkt der negativen Sollspannung 51. In die Anschlußleitung 19 sind drei gleiche Widerstände 52 eingebracht, so daß an den Abgriffpunkten 53 ein Drittel der Sollspannung anliegt. Damit liegt im normalen Betriebsfall die Eingangsspannung des Elektrometer-Differenz-Verstärkers, der aus den Operationsverstärkern 54, 55 und 56 gebildet wird, immer innerhalb des Akkumulatorspannungsbereichs, was eine unipolare Versorgung dieser Operationsverstärker 54, 55 und 56 aus demselben Akkumulator 2 ermöglicht. Die Schutzdioden 57 und 58, die mit den an die Anschlußpunkte 11 und 12 des Akkumulators 12 angeschlossenen Istwertleitungen 13 und 14 verbunden sind, schützen zusammen mit hochohmigen Widerständen 60 die Eingänge der Operationsverstärker bei extremen Verschiebungen der Spannungslagen.

Die nicht-invertierenden Eingänge der Operationsverstärker 54 und 55 sind über die hochohmigen Widerstände 60 mit den Abgriffpunkten 53 verbunden. Sie sind weiterhin über die Schutzdioden 57 und 58 mit den Anschlußpunkten 11 und 12 des Akkumulators 2 verbunden. Die Ausgänge der Operationsverstärker 54 und 55 sind direkt mit ihren invertierenden Eingängen gegengekoppelt. Ihre Ausgänge sind über zwei im Widerstandswert gleiche Widerstände 61 mit den Eingängen des dritten Operationsverstärkers 56 verbunden. Der nicht-invertierende Eingang des dritten Operationsverstärkers 56 ist über einen weiteren ebenfalls den gleichen Widerstandswert aufweisenden Widerstand 61 mit der Anschlußleitung 14 verbunden. Der Operationsverstärker 56 ist über einen im Widerstandswert mit den Widerständen 61 übereinstimmenden Rückkopplungswiderstand 61′ auf seinen invertierenden Eingang zurückgekoppelt.

An dem Ausgang 62 des Operationsverstärkers 56 liegt eine Spannung von einem Drittel der zwischen den Anschlußpunkten 50 und 51 anliegenden Sollspannung. Diese wird einem Fensterkomparator 63 zugeführt, der aus zwei Operationsverstärkern 64 und 65 aufgebaut ist. Diese Spannung wird mit einer an den anderen Eingängen der Operationsverstärker 64 und 65 anliegenden Spannung verglichen, die einem Drittel der Spannung des Akkumulators 2 entspricht. Diese wird durch einen aus den Widerständen 67 und 68 bestehenden Spannungsteiler erzeugt, wobei der Widerstand 67 den doppelten Widerstandswert des Widerstands 68 aufweist.

Der Fensterkomparator 63 weist eine Hysterese auf, die mit den Einstellwiderständen 70 und 71 im Rückkopplungskreis der Operationsverstärker 64 und 65 festgelegt ist. Dies verhindert ein instabiles Verhalten des Fensterkomparators 63. Die Ausgänge 72 und 73 der Operationsverstärker 64 und 65 sind mit Hilfe von zwei Schaltdioden 74 und 75 ODER-verknüpft und steuern über einen Verlustwiderstand 76 einen opto-elektronischen Koppler 77 an. Die verschiedenen opto-elektronischen Koppler 77 der einzelnen Vergleichsschaltungen 17 sind über die Ansteuerleitung 21 mit der Ansteuerschaltung 22 verbunden.

Vorzugsweise sind zwischen den Ausgängen 72 und 73 des Fensterkomparators 63 und der Leitung 14 des Überwachungsmodules 10 zwei Betriebsstundenzähler eingesetzt, die die Zeit messen, in denen sich der entsprechende Akkumulator 2 im Überspannungs- bzw. Unterspannungsbereich befunden hat.

In einer weiteren in der Fig. 3 nicht dargestellten Ausführungsform der Vergleichsschaltung 17 sind Verlustwiderstände 76 an die Ausgänge 72 und 73 angeschlossen, die über zwei die Dioden 74 und 75 ersetzende Leuchtdioden mit dem opto-elektronischen Koppler 77 verbunden sind. Somit ist zusätzlich zu den Betriebsstundenzählern eine laufende Erfassung des Überschreitens der Fenstergrenzwerte des Fensterkomparators 63 mit einer optischen Anzeige in einfacher Weise möglich.

Die Fig. 4 zeigt eine detailliertere Ausgestaltung der Ansteuerschaltung 22. Die Schalterzustandsleitung 41 ist mit einer Stromüberwachungseinheit 80 verbunden, die anhand eines Spannungsvergleichs zwischen der Schalterzustandsleitung 41 und der Masseleitung 6 feststellt, ob noch ein Triac-Paar 26 und 27 leitend ist. Nach einer kurzen Sicherheitsverzögerungszeit, die durch ein Verzögerungsglied 81 vorgegeben wird, wird ein Zähler 82 inkrementiert, der die nächste Akkumulatoradresse aus einem ROM ( Nur-Lese-Speicher ) oder einem EPROM 83 ( Programmierbaren-Nur-Lese-Speicher ) selektiert. Über eine Dekodierschaltung 84 wird eine der Steuerleitungen 29 ausgewählt, und mit einem Schließsignal beaufschlagt, dessen Länge durch ein Zündzeitglied 85 vorgegeben wird. Eine Startschaltung 86 initialisiert den Vorgang in der Stromüberwachungseinheit 80 und überwacht das Fortschreiten des Zählers 82 sowie die Dekodierschaltung 84. Anstelle des Zählers 82 und dem EPROM 83 kann auch eine andere, auf dem Über- oder Unterschreiten eines Vergleichswerts, der in einer Schaltung gemäß Fig. 3 ermittelt wird, beruhende Schaltung vorgesehen sein, mit der eine auszuwählende Steuerleitung 29 vorbestimmt wird.

Die Fig. 5 zeigt schließlich eine andere Ausgestaltungsmöglichkeit der Vergleichsschaltung 17. Ein Analog-Digital-Wandler 91, der mit der Spannung zwischen den Anschlußleitungen 5 und 6 beaufschlagt ist, erstellt ein digitales, der Sollspannung entsprechendes Signal, das über die Digitalleitung 92 in die Vergleichsschaltungen 17 eingespeist wird. Das digitale Signal kann in Pulsbreitenmodulation oder in frequenzkodierter Form vorliegen. In einem opto-elektronischen Koppler 93 wird das digitale Signal zur Potentialtrennung übertragen und in einem zu jeder Vergleichsschaltung 17 gehörenden Digital-Analog-Wandler 94 in ein analoges Signal zurückgewandelt, das in einem Komparator 90 mit der an den Anschlußpunkten 11 und 12 abgegriffenen Ist-Spannung des jeweiligen Akkumulators 2 verglichen wird.

Die Auswahl der mit einem Schließsignal beaufschlagten Steuerleitung 29 wird in einer einfachen Ausgestaltung der Ansteuerschaltung 22 zufällig aus einem in dieser vorgegebenen Rauschsignal bestimmt. Die abwechselnd schnell parallel zu den Akkumulatoren 2 geschalteten Kondensatoren 31 gestatten es, daß Akkumulatoren 2 mit zu hoher Spannung ihre Ladung jeweils an die Kondensatoren 31 abgeben, während diejenigen mit zu niedriger Spannung Ladung aufnehmen.

Neben einem kontinuierlichen Betrieb des Überwachungseinrichtung für Akkumulatoren 1 kann in einem anderen Ausführungsbeispiel eine Zeitschaltung in der Ansteuerschaltung 22 vorgesehen sein, die eine Folge von Schließsignalen nur in vorgegebenen Zeitabständen aussendet und die Ladungszustände der Akkumulatoren 2 abfragt. Diese Zeitabstände mit darauf folgenden Ausgleichsvorgängen vorbestimmter Zeitdauer sind dann abhängig von der gleichlaufenden Ladung bzw. Entladung der Akkumulatoren 2 verlängerbar oder werden bei Störungen verkürzt.

## Patentansprüche

1. Überwachungseinrichtung (1) für eine Vielzahl von in Reihe geschalteten, gleichartigen Akkumulatoren (2) mit einer Steuerschaltung (22) zum Zuschalten eines elektrischen Speichers (31) parallel zu einem der Akkumulatoren (2), **dadurch gekennzeichnet**, daß die Polanschlüsse (11,12) jedes Akkumulators (2) über ein zugehöriges Schalterpaar (25,26,27) an einen, den elektrischen Speicher bildenden Kondensator (31) angeschlossen sind und daß die Schalterpaare (25,26,27) über Steuerleitungen (29) mit der Steuerschaltung (22) verbunden sind, wobei die Steuerschaltung (22) gleichzeitig jeweils höchstens eine Steuerleitung (29) mit einem Schließsignal beaufschlagt.

2. Überwachungseinrichtung für Akkumulatoren nach Anspruch 1, dadurch gekennzeichnet, daß die Auswahl der mit einem Schließsignal beaufschlagten Steuerleitung (29) aus einem in der Steuerschaltung (22) vorgegebenen Rauschsignal zufällig erfolgt.

3. Überwachungseinrichtung nach Anspruch 1, dadurch gekennzeichnet, daß in der Steuerschaltung (22) eine Speichervorrichtung (83) vorgesehen ist, in der eine Auswahlsequenz für die mit einem Schließsignal zu beaufschlagende Steuerleitung (29) abgespeichert ist.

4. Überwachungseinrichtung nach Anspruch 1, dadurch gekennzeichnet, daß mindestens eine Vergleichsschaltung (17) vorgesehen ist, mit der die Abweichung der jeweiligen Akkumulatorspannung von einer Sollspannung nach oben und nach unten meßbar ist, deren drei verschiedene Werte anzeigendes Ausgangssignal in der Steuerschaltung (22) als Differenzsignal für den jeweiligen Akkumulator (2) speicherbar ist, und daß mit der Steuerschaltung (22) Schließsignale für Schalterpaare (25,26,27) von solchen Akkumulatoren (2) hintereinander erzeugbar sind, deren Differenzsignale den ersten und den dritten Wert der drei verschiedenen Werte annehmen.

5. Überwachungseinrichtung nach Anspruch 1 oder Anspruch 4, dadurch gekennzeichnet, daß genau eine Vergleichsschaltung (17) vorgesehen ist, mit der die an dem Kondensator (31) anliegende Spannung zu Zeiten erfaßbar ist, in denen keine Steuerleitung (29) mit einem Schließsignal beaufschlagt ist.

6. Überwachungseinrichtung nach Anspruch 4, dadurch gekennzeichnet, daß genau eine Vergleichsschaltung (17) je Akkumulator (2) vorgesehen ist, deren jeweiliger Ausgang (77) mit einem dem jeweiligen Akkumulator (2) zugeordneten Eingang der Steuerschaltung (22) verbunden ist.

7. Überwachungseinrichtung nach einem der Ansprüche 1 bis 6, dadurch gekennzeichnet, daß die Schalterpaare (25,26,27) durch jeweils ein Paar von Triacs (26′,27′) gebildet werden.

8. Überwachungseinrichtung nach Anspruch 7, dadurch gekennzeichnet, daß die Kathoden der Triacs (26′,27′) jeweils mit den Polanschlüssen (11,12) der Akkumulatoren (2) verbunden sind, und daß zwischen den Gate-Anschlüssen der Triacs (26′,27′) der Empfangsteil eines opto-elektronischen Kopplers (44) und ein Verlustwiderstand (43) in Reihe geschaltet sind, wobei ein von dem opto-elektronischen Koppler (44,45) übertragenes Schließsignal der Steuerleitung (29) in Gestalt eines Zündimpulses auf der Gate-Leitung (42) die Triacs (26′,27′) leitend schaltet.

9. Überwachungseinrichtung nach einem der Ansprüche 1 bis 8, dadurch gekennzeichnet, daß der Kondensator (31) eine Anzahl von Kondensatorelementen (31) umfaßt, die der Anzahl der Akkumulatoren (2) entspricht.

10. Überwachungseinrichtung nach Anspruch 9, dadurch gekennzeichnet, daß zwischen dem das höhere Potential aufweisenden Anschluß des zu dem mit der Masseleitung (6) verbundenen Akkumulator (2) gehörenden Kondensators (31) und der Masseleitung (6) ein Widerstand (40) vorgesehen ist und daß eine Schalterzustandsleitung (41) den anderen Anschluß dieses Kondensators (31) mit einer Stromüberwachungseinheit (80) der Steuerschaltung (22) verbindet, so daß ein Schließsignal nur dann erzeugbar ist, wenn das Potential der Schalterzustandsleitung (41) kleiner oder gleich dem Potential der Masseleitung (6) ist.

11. Überwachungseinrichtung nach einem der Ansprüche 1 bis 10, dadurch gekennzeichnet, daß in Reihe mit mindestens einem der Schalter (26,27) der jeweiligen Schalterpaare (25,26,27) eine Spule (30) in den zu dem Kondensator (31) führenden Leitungen (32 oder 33) vorgesehen ist.

## Claims

1. A monitoring device (1) for a plurality of series-connected similar batteries (2) comprising a control circuit (22) for connecting an electrical storage means (31) in parallel with one of the batteries (2), characterised in that the pole terminals (11, 12) of each battery (2) are connected by way of an associated pair of switches (25, 26, 27) to a capacitor (31) forming the electrical storage means and that the pairs of switches (25, 26, 27) are connected to the control circuit (22) by way of control lines (29), wherein the control circuit (22) simultaneously supplies at most one respective control line (29) with a closing signal.

2. A monitoring device for batteries according to claim 1 characterised in that the selection of the control line (29) which is supplied with a closing signal is effected randomly from a noise signal which is predetermined in the control circuit (22).

3. A monitoring device according to claim 1 characterised in that provided in the control circuit (22) is a storage device (83) for storing a selection sequence for the control line (29) which is to be supplied with a closing signal.

4. A monitoring device according to claim 1 characterised in that there is provided at least one comparison circuit (17) with which the deviation of the respective battery voltage from a reference voltage upwardly and downwardly can be measured, and whose output signal, which displays three different values, can be stored in the control circuit (22) as a difference signal for the respective battery (2) and that closing signals can be successively produced with the control circuit (22) for pairs of switches (25, 26, 27) of such batteries (2) whose difference signals assume the first and the third values of the three different values.

5. A monitoring device according to claim 1 or claim 4 characterised in that there is provided just one comparison circuit (17) with which the voltage applied to the capacitor (31) can be ascertained at times at which no control line (29) is supplied with a closing signal.

6. A monitoring device according to claim 4 characterised in that there is provided just one comparison circuit (17) per battery (2), the respective output (77) of the comparison circuit being connected to an input of the control circuit (22), said input being associated with the respective battery (2).

7. A monitoring device according to one of claims 1 to 6 characterised in that the pairs of switches (25, 26, 27) are formed by a respective pair of triacs (26′, 27′).

8. A monitoring device according to claim 7 characterised in that the cathodes of the triacs (26′, 27′) are respectively connected to the pole terminals (11, 12) of the batteries (2) and that connected in series between the gate terminals of the triacs (26′, 27′) are the receiving portion of an opto-electronic coupler (44) and a dissipative resistor (43), wherein a closing signal of the control line (29), which is transmitted by the opto-electronic coupler (44, 45), in the form of a trigger pulse on the gate line (42), switches the triacs (26′, 27′) to a conducting condition.

9. A monitoring device according to one of claims 1 to 8 characterised in that the capacitor (31) includes a number of capacitor elements (31), which corresponds to the number of batteries (2).

10. A monitoring device according to claim 9 characterised in that a resistor (40) is provided between the earth line (6) and the connection, which is at the higher potential, of the capacitor (31) belonging to the battery (2) connected to the earth line (6), and that a switch status line (41) connects the other connection of said capacitor (31) to a current monitoring unit (80) of the control circuit (22) so that a closing signal can be produced only when the potential of the switch status line (41) is lower than or equal to the potential of the earth line (6).

11. A monitoring device according to one of claims 1 to 10 characterised in that a coil (30) is provided in series with at least one of the switches (26, 27) of the respective pairs of switches (25, 26, 27) in the lines (32 or 33) leading to the capacitor (31).

## Revendications

1. Dispositif de surveillance (1) pour un ensemble d'accumulateurs (2) identiques reliés en série, avec un circuit de commande (22) pour la mise en circuit d'un stockage d'énergie électrique (31) en parallèle sur l'un des accumulateurs (2), caractérisé en ce que les bornes de raccordement (11,12) de chaque accumulateur (2) sont connectées à un condensateur (31) qui constitue le stockage d'énergie électrique, par l'intermédiaire d'une paire correspondante d'interrupteurs (25, 26, 27), et en ce que les paires d'interrupteurs (25, 26, 27) sont reliées par des lignes de commande (29) au circuit de commande (22), un signal de fermeture ne pouvant être envoyé qu'à une seule ligne de commande (29) à la fois.

2. Dispositif de surveillance pour accumulateurs selon la revendication 1, caractérisé en ce que la sélection de la ligne de commande (29) recevant un signal de fermeture s'effectue d'une façon aléatoire selon un signal de bruit déterminé du circuit de commande (22).

3. Dispositif de surveillance selon la revendication 1, caractérisé en ce que dans le circuit de commande (22) est prévu un dispositif de mémorisation (83) dans lequel est enregistrée une séquence de sélection de la ligne de commande (29) qui doit recevoir le signal de fermeture.

4. Dispositif de surveillance selon la revendication 1, caractérisé en ce qu'il est prévu au moins un circuit comparateur (17) permettant de mesurer l'écart en plus ou en moins par rapport à une tension de consigne de la tension de l'accumulateur concerné, les trois valeurs différentes de signal de sortie indicateur pouvant être enregistrées dans le circuit de commande (22) en tant que signal différentiel pour l'accumulateur (2) concerné, et en ce qu'avec le circuit de commande (22), il est possible d'émettre, à la suite les uns des autres, des signaux de fermeture des paires d'interrupteurs (25, 26, 27) de ces accumulateurs (2) dont les signaux différentiels peuvent prendre la première ou la troisième des trois valeurs différentes.

5. Dispositif de surveillance selon la revendication 1 ou la revendication 4, caractérisé en ce qu'il est prévu un seul circuit comparateur (17) permettant de mesurer la tension aux bornes du condensateur (31) pendant le temps où aucune ligne de commande (29) ne reçoit de signal de fermeture.

6. Dispositif de surveillance selon la revendication 4, caractérisé en ce qu'il est prévu un seul circuit comparateur (17) par accumulateur (2), dont la sortie correspondante (77) est raccordée à l'entrée du circuit de commande (22) qui est affectée à cet accumulateur (2).

7. Dispositif de surveillance selon l'une quelconque des revendications 1 à 6, caractérisé en ce que les paires d'interrupteurs (25, 26, 27) sont constituées chacune par une paire de triacs (26′, 27′).

8. Dispositif de surveillance selon la revendication 7, caractérisé en ce que les cathodes des triacs (26′, 27′) sont reliées aux bornes de raccordements respectives (11, 12) des accumulateurs (2), et en ce qu'entre les gâchettes des triacs (26′, 27′) sont reliées en série la partie réceptrice d'un coupleur optoélectronique (44) et une résistance chutrice (43), l'un des signaux de fermeture du circuit de commande (29) transmis par le coupleur optoélectronique (44, 45) se présentant sous la forme d'une impulsion d'allumage sur la ligne de commande de gâchette (42) pour allumer les triacs (26′, 27′).

9. Dispositif de surveillance selon l'une quelconque des revendications 1 à 8, caractérisé en ce que le condensateur (31) est constitué par un ensemble d'éléments condensateurs (31) dont le nombre correspond au nombre d'accumulateurs (2).

10. Dispositif de surveillance selon la revendication 9, caractérisé en ce qu'une résistance (40) a été prévue entre le conducteur de masse (6) et le raccordement situé au potentiel le plus élevé du condensateur (31) appartenant à l'accumulateur (2) relié au conducteur de masse (6), et en ce qu'une ligne d'état de commutation (41) relie le second raccordement de ce condensateur (31) à une unité de surveillance de courant (80) du circuit de commande (22), de telle sorte qu'un signal de fermeture ne peut être émis que si le potentiel de la ligne d'état de l'interrupteur (41) est inférieur ou égal au potentiel du conducteur de masse (6).

11. Dispositif de surveillance selon l'une quelconque des revendications 1 à 10, caractérisé en ce qu'une bobine (30) est prévue en série avec au moins l'un des interrupteurs (26, 27) de la paire correspondante d'interrupteurs (25, 26, 27) dans les lignes (32 ou 33) conduisant au condensateur (31).
